# EUROPÄISCHE PATENTSCHRIFT

(11) **EP 0 800 433 B1**
(45) Veröffentlichungstag und Bekanntmachung des Hinweises auf die Patenterteilung: **20.10.1999**
(21) Anmeldenummer: 95938352.2
(22) Anmeldetag: 29.11.1995
(51) Int. Cl.: B23K 20/10, B23K 20/00

(54) **VERFAHREN ZUM PRÜFEN VON DURCH ULTRASCHALLDRAHTBONDEN HERGESTELLTEN VERBINDUNGEN**
METHOD OF TESTING CONNECTIONS PRODUCED USING ULTRASONIC WIRE BONDING
PROCEDE DE CONTROLE DE CONNEXIONS REALISEES PAR MICROCABLAGE AUX ULTRASONS

(30) Priorität: 29.12.1994 DE 4447073
(43) Veröffentlichungstag der Anmeldung: 15.10.1997
(73) Patentinhaber: ROBERT BOSCH GMBH, 70442 Stuttgart (DE)
(72) Erfinder: ALTPETER, Arno, D-71067 Sindelfingen (DE); RIEDMÜLLER, Franz, D-71706 Markgröningen (DE); REINOLD, Manfred, D-71701 Schwieberdingen (DE)
(86) Internationale Anmeldenummer: DE9501686
(87) Internationale Veröffentlichungsnummer: WO9620806

(56) Entgegenhaltungen:
- EP-A- 0 247 291
- EP-A- 0 368 533
- EP-A- 0 498 936
- DE-A- 3 429 776
- US-A- 3 890 831
- US-A- 4 040 885
- US-A- 4 606 490
- US-A- 4 998 664

## Beschreibung

### Stand der Technik

Die Erfindung geht aus von einem Verfahren zum Prüfen von durch Ultraschalldrahtbonden hergestellten Verbindungen, Bei bekannten Verfahren wird neben einer optischen Beurteilung der Verbindungsstelle die Festigkeit im Scher-, Zug- und Schälversuch ermittelt. Dieses Verfahren läßt sich nur stichprobenweise durchführen, so daß es den hohen Qualitätsanforderungen einer modernen Massenfertigung nicht entsprechen kann.

EP-A-368 533 offenbart ein Verfahren zum Prüfen von durch Ultraschalldrahtbonden hergestellten Verbindungen, bei welchem die Bondparameter während des Bondvorgangs ermittelt und ausgewertet werden und daraus die Festigkeit der Verbindung als maßgebende Größe für die Bondgüte ermittelt wird, und wobei als Bondparameter der zeitliche Verlauf der Drahtdeformation während des Bondvorgangs erfaßt wird, die aufgenommenen Istwerte der Drahtdeformation jeweils mit in einem Prozeßsicherungsbaustein gespeicherten, einen vorgegebenen Qualitätsstandard entsprechenden Sollwerten verglichen werden, und bei Abweichung eines der Istwerte von dem entsprechenden Sollwert die Bondgüte als nicht ausreichend bewertet wird. US-A-4606490 offenbart ein Verfahren zum Prüfen von durch Ultraschalldrahtbonden hergestellten Verbindungen, bei welchem die Festigkeit der Verbindung als maßgebende Größe für die Bondgüte ermittelt wird, wobei als für die Festigkeit der Verbindung maßgebender Parameter der zeitliche Verlauf der Bondkeilamplitude während des Bondvorgangs erfaßt und durch Vergleich mit in einem Prozeßsicherungsbaustein gespeicherten, einem vorgegebenen Qualitätsstandard entsprechenden Daten bewertet wird.

### Vorteile der Erfindung

Die erfindungsgemäße Anordnung mit den Merkmalen des Hauptanspruchs hat demgegenüber den Vorteil, daß ein befriedigendes Prüfen von Verbindungen nur durch Vergleich von bei einem ersten und einem zweiten Zeitpunkt aufgenommenen Istwerten mit Sollwerten möglich ist, wenn diese die Istwerte der Drahtdeformation und der Bondkeilamplitude sind.

Durch die in den Unteransprüchen aufgeführten Maßnahmen sind vorteilhafte Ausgestaltungen des Verfahrens gemäß dem Hauptanspruch möglich.

Besonders vorteilhaft ist es, wenn der Prozeßsicherungsbaustein bei Feststellung einer den vorgegebenen Qualitätsstandard nicht entsprechenden Verbindung ein Signal für das Ausschleusen der betreffenden Bauteile erzeugt. Dadurch läßt sich bei entsprechender Ausgestaltung erreichen, daß der Fertigungsfluß durch einen Ausschleusvorgang nicht unterbrochen werden muß.

Der Verlauf der Drahtdeformation während des Bondvorganges kann einfach und sicher durch einen berührungslos arbeitenden Sensor erfaßt werden.

Die Bondkeilamplitude läßt sich vorteilhaft durch Erfassen und Auswerten der Stromaufnahme der Ultraschallvorrichtung ermitteln.

Das erfindungsgemäße Verfahren ist vorzugsweise bei Keil-Keil-Bondschweißverfahren anwendbar.

### Zeichnung

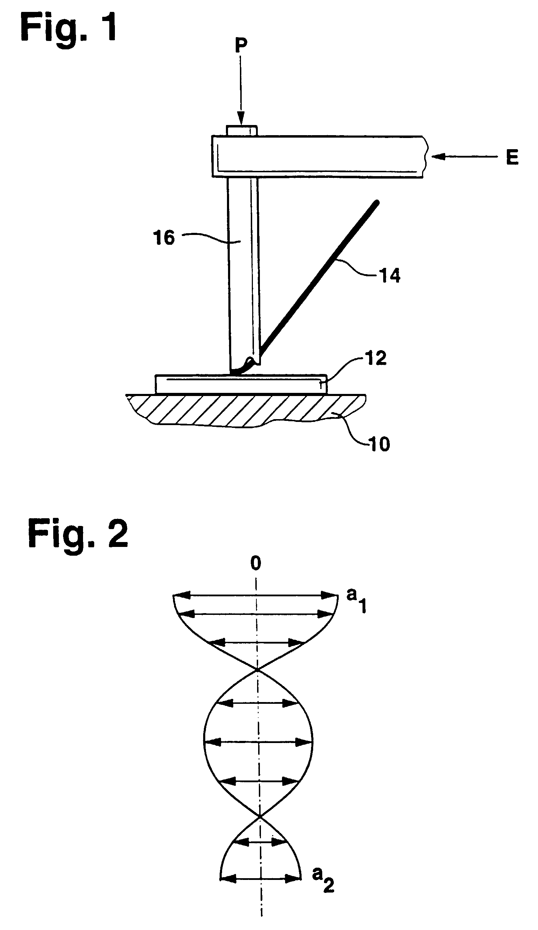

Eine zur Durchführung des erfindungsgemäßen Verfahrens geeignete Schweißvorrichtung ist in der Zeichnung schematisch dargestellt und in der nachfolgenden Beschreibung erläutert. Es zeigen Figur 1 die im vorliegenden Zusammenhang interessierenden Teile einer Keil-Keil-Bondschweißvorrichtung, Figur 2 den Schwingungsverlauf im Bondkeilwerkzeug nach Figur 1, und die Figuren 3 und 4 die in Vorversuchen für einen bestimmten Anwendungsfall ermittelten zeitlichen Verläufe der auf den Draht übertragenen Amplituden und der Drahtdeformation für saubere und für verunreinigte Kontaktflächen am Draht und am Substrat.

### Beschreibung des Ausführungsbeispiels

Die Bondschweißvorrichtung gemäß Figur 1 hat eine feste Auflage 10 für das Substrat 12, an welches der Draht 14 durch Bonden angeschweißt werden soll. Dazu dient ein Bondkeilwerkzeug 16, das in üblicher Weise ausgebildet ist und mit dem Draht 14 zusammenwirkt. Das Bondkeilwerkzeug 16 wird beim Bondprozeß durch eine Kraft P gegen das anzuschließende Drahtende und das Substrat 12 gedrückt. Außerdem überträgt eine nicht dargestellte Ultraschallvorrichtung eine Schwingungsenergie E auf das Bondkeilwerkzeug 16, deren Amplitudenverlauf in Längsrichtung des Bondkeilwerkzeugs 16 in Figur 2 dargestellt ist.

Die Kraft P und die Schwingungsenergie E sind so bemessen, daß bei sauberen Kontaktflächen am Draht 14 und Substrat 12 die Zugfestigkeit der Verbindung einen vorgegebenen Wert erreicht bzw. überschreitet. Aus Figur 2 ist ersichtlich, daß die Eingangsamplitude a₁ der Schwingungsenergie E größer als die auf den Draht 14 übertragene Ausgangsamplitude a₂ ist. Dieser durch die Reibung zwischen Draht 14, Substrat 12 und Bondkeilwerkzeug 16 hervorgerufene Dämpfungseffekt ist umso kleiner, je stärker die Kontaktflächen von Draht und Substrat durch Handschweiß, Öl oder gleichen verunreinigt sind. Die vorliegende Erfindung macht sich diesen Umstand dadurch zunutze, daß während des Bondprozesses die Ausgangsamplitude a₂ abgefragt und bewertet wird.

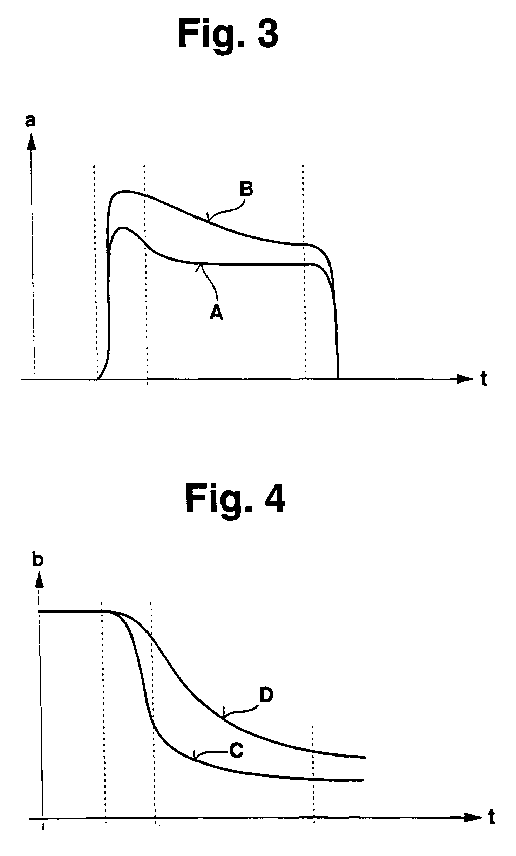

Zu diesem Zweck werden durch Vorversuche, die auf einen bestimmten Anwendungsfall abgestellt sind, die Größen bzw. zeitlichen Verläufe der Ausgangsamplitude a₂ für saubere und für verunreinigte Kontaktflächen ermittelt. Dabei ergeben sich gemäß Schaubild nach Figur 3 die Kurve A für saubere und die Kurve B für verunreinigte Kontaktflächen. Die Kurve A wird nun als Masterkurve in einem Prozeßsicherungsbaustein gespeichert, der während des zum Zeitpunkt t₀ beginnenden Bondprozesses an zwei verschiedenen Zeitpunkten t₁ und t₂ abgefragt wird. Der Prozeßsicherungsbaustein entscheidet nun, ob die zu diesen Zeitpunkten ermittelten Werte der Ausgangsamplitude a₂ dem Wert auf der Kurve A entsprechen bzw. innerhalb eines vorgegebenen Toleranzbereiches dazu liegen. Wenn das nicht zutrifft, kann der Prozeßsicherungsbaustein ein Signal für die Notwendigkeit des Ausschleusens der betreffenden Bauteile auslösen.

Bei den auf einen bestimmten Anwendungsfall abgestellten Vorversuchen wird auch die Geschwindigkeit bzw. der zeitliche Verlauf der Drahtdeformation als ein weiterer Parameter für die Festigkeit bzw. Güte der Bondverbindung ermittelt. Dem Schaubild nach Figur 4 ist über der Prozeßzeit t der Abstand b aufgetragen, welcher die Arbeitsfläche des Bondkeilwerkzeugs 16 zu einer Bezugsebene an der Auflage 10 bzw. dem Substrat 12 einnimmt. Bei sauberen Kontaktflächen ergibt sich ein Deformationsverlauf nach Kurve C, bei verunreinigten Kontaktflächen stellt sich ein verlangsamter Verlauf nach Kurve D ein. Die Kurve C wird als Masterkurve in den Prozeßsicherungsbaustein eingespeichert und - wie die Kurve A - zur Beurteilung der zu den Zeitpunkten t₁ und t₂ ermittelten Istwerte der Drahtdeformation herangezogen.

Die Messungen können so ausgewertet werden, daß ein Signal für das Ausschleusen von Bauteilen erfolgt, wenn nur ein Meßwert außerhalb des vorgegebenen Toleranzbereiches zur entsprechenden Masterkurve A bzw. C liegt. Das Verfahren kann aber auch so gewählt werden, daß die zum Zeitpunkt t₂ erfaßten Meßwerte höher bewertet werden als die zum Zeitpunkt t₁ erfaßten, oder daß ein Fehlersignal erst erfolgt, wenn zwei oder drei der vier Meßwerte nicht mehr in den vorgegebenen Toleranzbereich fallen.

## Patentansprüche

1. Verfahren zum Prüfen Von durch Ultraschalldrahtbonden hergestellten Verbindungen, bei welchem die Bondparameter während des Bondvorgangs ermittelt und ausgewertet werden und daraus die Festigkeit der Verbindung als maßgebende Größe für die Bondgüte ermittelt wird, wobei als Bondparameter der zeitliche Verlauf der Drahtdeformation und der zeitliche Verlauf der Bondkeilamplitude während des Bondvorgangs erfaßt wird, wobei bei einem ersten Zeitpunkt (t₁) und bei einem zweiten Zeitpunkt (t₂) die aufgenommenen Istwerte der Drahtdeformation und der Bondkeilamplitude jeweils mit in einem Prozeßsicherungsbaustein gespeicherten, einen vorgegebenen Qualitätsstandard entsprechenden Sollwerten verglichen werden, und wobei bei Abweichung eines der Istwerte von dem entsprechenden Sollwert die Bondgüte als nicht ausreichend bewertet wird.

2. Verfahren nach Anspruch 1, dadurch gekennzeichnet, daß der Prozeßsicherungsbaustein bei Feststellung einer dem vorgegebenen Qualitätsstandard nicht entsprechenden Ausführung der Verbindung ein Signal für das Ausschleusen der betreffenden Bauteile erzeugt.

3. Verfahren nach Anspruch 1 oder 2, dadurch gekennzeichnet, daß der Verlauf der Drahtdeformation während des Bondvorgangs durch einen berührungslos arbeitenden Sensor erfaßt wird.

4. Verfahren nach einem der vorhergehenden Ansprüche, dadurch gekennzeichnet, daß die Bondkeilamplitude durch Erfassen der Stromaufnahme der Ultraschallvorrichtung ermittelt wird.

## Claims

1. Method for testing connections produced using ultrasonic wire bonding, in which the bond parameters are determined and evaluated during the bonding operation and from this the strength of the connection is determined as decisive variable for the bond quality, it being the case that the temporal variation in the wire deformation and the temporal variation in the bond wedge amplitude during the bonding operation are detected as bond parameters, the detected actual values of the wire deformation and the bond wedge amplitude respectively being compared at a first instant (t₁) and at a second instant (t₂) with desired values stored in a process control module and corresponding to a prescribed quality standard, and the bond quality being evaluated as inadequate in the event of deviation of one of the actual values from the corresponding desired value.

2. Method according to Claim 1, characterized in that in the event of finding a version of the connection not corresponding to the prescribed quality standard, the process control module generates a signal for ejecting the relevant components.

3. Method according to Claim 1 or 2, characterized in that the variation in the wire deformation during the bonding operation is detected by a sensor operating in a contactless fashion.

4. Method according to one of the preceding claims, characterized in that the bond wedge amplitude is determined by detecting the power consumption of the ultrasonic device.

## Revendications

1. Procédé de contrôle de liaisons réalisées par un câble aux ultrasons, selon lequel on détermine les paramètres de soudage pendant l'opération de soudage et on les exploite pour en déduire la résistance de la liaison comme grandeur déterminante de la qualité du soudage, selon lequel, on utilise comme paramètres de soudage, le profil chronologique de la déformation du fil et le profil chronologique de l'amplitude du coin de soudage pendant l'opération de soudage, et à un premier instant (t₁) et à un second instant (t₂), on mémorise les valeurs réelles enregistrées de la déformation du fil et de l'amplitude de coin de soudage dans un composant de protection de procédé, on compare à une valeur de consigne correspondant à une norme de qualité, prédéterminée et en cas de différence d'une valeur réelle par rapport à la valeur de consigne correspondante, on considère que la qualité du soudage n'est pas suffisante.

2. Procédé selon la revendication 1,
caractérisé en ce que
le composant de protection du procédé génère un signal pour l'élimination du composant concerné lorsqu'il constate qu'une réalisation de la liaison ne correspond pas à une norme de qualité prédéterminée.

3. Procédé selon la revendication 1 ou 2,
caractérisé en ce qu'
on détecte le profit de la déformation du fil pendant l'opération de soudage par un capteur fonctionnant sans contact.

4. Procédé selon l'une des revendications précédentes,
caractérisé en ce qu'
on détermine l'amplitude de coin de soudage par la saisie de l'intensité du courant reçu par le dispositif à ultrasons.
